# EUROPÄISCHE PATENTSCHRIFT

(11) **EP 3 479 082 B1**
(45) Veröffentlichungstag und Bekanntmachung des Hinweises auf die Patenterteilung: **01.11.2023**
(21) Anmeldenummer: 17739212.3
(22) Anmeldetag: 30.06.2017
(51) Int. Cl.: G01J 1/42, C09K 9/02, H10K 30/30, H10K 39/30, H10K 85/10

(54) **UV-DOSIMETER MIT FARBÄNDERUNG**
UV DOSIMETER WITH COLOUR CHANGE
DOSIMÈTRE POUR UV À CHANGEMENT DE COULEUR

(30) Priorität: 30.06.2016 DE 102016007932
(43) Veröffentlichungstag der Anmeldung: 08.05.2019
(73) Patentinhaber: Thüringisches Institut für Textil- und Kunststoff-Forschung e.V., 07407 Rudolstadt (DE)
(72) Erfinder: SCHRÖDNER, Mario, 07407 Rudolstadt (DE); SCHACHE, Hannes, 07407 Rudolstadt (DE); BLANKENBURG, Lars, 07768 Kahla (DE); KONKIN, Gulnara, 07407 Rudolstadt (DE)
(74) Vertreter: Plate, Jürgen
(86) Internationale Anmeldenummer: PCT/EP2017/066281
(87) Internationale Veröffentlichungsnummer: WO 2018/002306

(56) Entgegenhaltungen:
- DE-A1-102007 041 395
- GB-A- 2 437 362

## Beschreibung

Die Erfindung betrifft ein auf einer einfachen elektronischen Schaltung basierendes UV-Dosimeter, bestehend nur aus einem oder mehreren UV-Dosimeter-Modulen, welche wiederum nur aus einer UV-Fotodiode und einem elektrochromen Element, welches die akkumulierte Strahlendosis in Abhängigkeit von Bestrahlung und Zeit als Farbänderung der elektrochromen Elemente anzeigt, zusammengesetzt sind. Das elektrochrome Element übernimmt hierbei sowohl die Funktion der Ladungsakkumulation als auch der farblichen Anzeige der Dosis. Das Dosimeter funktioniert ohne zusätzliche Stromquelle, wie z.B. Batterien oder Solarzellen. In einer bevorzugten Ausführungsform kann das UV-Dosimeter als dünnes, flexibles Foliendosimeter preisgünstig mittels Druck- und Beschichtungstechniken hergestellt werden. Im Gebrauch kann es platzsparend direkt an den exponierten Oberflächen angebracht werden.

Bekannte UV-Dosimeter basieren häufig auf fotochromen Schichten, die bei Bestrahlung ihre Farbe ändern. Solche Dosimeter können als Einwegartikel preiswert in Form kleiner Teststreifen hergestellt werden.

Bei rein visueller Auswertung erhält man praktisch nur eine qualitative Aussage durch Vergleich mit einer Referenzfarbskala. Mittels fotometrischer Auswertung erhält man auch quantitative Aussagen, jedoch bedarf dies eines zusätzlichen Messvorganges mit einem geeigneten Messgerät. Für die Dosisbestimmung in strahlenhärtenden Verfahren in der Druck- und Beschichtungsindustrie wird so ein System von der Firma Hönle AG unter dem Namen UV Scan angeboten. Jedoch ist dies insbesondere für portable Anwendungen im Freizeitbereich (z.B. Outdooraktivitäten) oder im Arbeitsschutz in exponierter Umgebung (Baustellen, Landwirtschaft) eher hinderlich. Da die Farbänderung reversibel ist, kann bei Unterbrechung der Einstrahlung (z.B. zeitweise Bewölkung) die Färbung zurückgehen, wodurch eine Dosisbestimmung nicht mehr möglich ist. Das ist ein klarer Nachteil, der die Anwendung weitgehend auf Fälle mit kontinuierlicher Einstrahlung begrenzt, z.B. industrielle Prozesse.

Im Gegensatz zu den fotochromen UV-Dosimetern basieren bekannte elektronische Dosimeter auf einem UV-sensitiven Bauelement, wie z.B. einer Fotodiode oder einem Fotowiderstand. Dieses ist Bestandteil einer elektronischen Schaltung, die die vom UV-Sensor generierte Ladung über die Messzeit integriert und schließlich die gemessene Dosis zur Anzeige bringt. Beispiele findet man in US4428050 und US3710115, wobei die Angaben zu den Schaltungen unterschiedlich detailliert sind. Zusätzlich oder alternativ zur Messwertanzeige können die Dosimeter noch mit einer optischen oder akustischen Warnfunktion versehen sein, die aktiviert wird, wenn ein bestimmter Sollwert erreicht ist. Diese Schaltungen werden mit diskreten Bauelementen aufgebaut und sind deswegen nicht beliebig kompakt und preiswert und vor allem nicht flexibel herzustellen. Darüber hinaus benötigen sie meist eine Stromversorgung (Netzanschluss, Batterie o.ä.).

In der WO 86/03319 wird eine energieautarke Schaltung für ein elektronisches UV-Dosimeter mit einer elektroakustischen Warnfunktion beschrieben. Die Schaltung beinhaltet einen optischen Sensor, Widerstände, Kondensatoren, einen Vorstärker, einen Komparator, Schalter, Dioden, einen Piezowandler und eine Solarzelle zur Energieversorgung. Zur Herstellung der Schaltung werden keine Angaben gemacht. Die Schaltung befindet sich in einem Gehäuse mit Fenster und ist somit ebenfalls nicht dünn, flexibel und auch nicht wirklich preiswert.

In DE 69102804 T wird ein anderes elektronisches Dosimeter für Gamma-, UV-, Röntgen- oder Teilchenstrahlen bestehend aus einem Detektor, einer Kalenderuhr, einem Speicher, einem Mikroprozessor, einer Energieversorgung, einem Display und/oder einem Alarm beschrieben. Die Schaltung wird mit diskreten Bauelementen aufgebaut und kann z.B. in eine Scheckkarte integriert werden. In dem Gebrauchsmuster G9313246.8 wird ein UV-Dosimeter mit einem Fotodetektor aus einem Halbleiter mit einem Bandabstand größer als 2,25 eV, einer Eingabeeinrichtung, einer Signalverarbeitung und einer optischen und/oder akustischen Ausgabeeinrichtung beansprucht. Weitere Elemente dieses Dosimeters können sein: Linsen, Speicher, Solarzelle zur Energieversorgung, Filter. Dieses Dosimeter lässt sich miniaturisieren und z.B. in Scheckkarten, Uhren, Brillen, Dosen oder Bekleidung integrieren. Beide Dosimeter sind jedoch noch nicht flexibel genug um als Film- oder Foliendosimeter angewendet zu werden. Die Fertigung wäre überdies nicht ausreichend einfach und preiswert, um es als Einmalartikel zu nutzen.

Gemäß der Patentschrift GB 2437362 A wird zur Dosisbestimmung ein photovoltaisches Element verwendet, dessen Wirkungsgrad sich durch Photodegradation ändert. Der Wirkungsgrad korreliert mit der absorbierten Dosis und wird mittels einer nicht näher beschriebenen Schaltung registriert (Ansprüche 8 und 19). Beispielhaft werden Multi-, Volt-, Amper- oder Sourcemeter genannt, bei denen davon auszugehen ist, dass es sich um klassische elektronische Geräte handelt, die einer flexiblen und dünnen Ausführung als Foliendosimeter entgegen stehen. Als optische Warnelemente werden elektrochrome Elemente oder LED vorgeschlagen oder alternativ ein akustisches Signal.

In DE 10 2013 113445 A1 wird ein UV-Dosimeter bestehend aus einer UV-Messeinrichtung, einer Datenverarbeitungseinrichtung, einer Anzeige und/oder einem Display offenbart. In Anspruch 16 wird als zusätzliches Element noch eine Solarzelle oder Batterie als Energieversorgung angegeben. Es werden keine Angaben gemacht, wie aus dem Signal der UV-Messeinrichtung ein Dosiswert gebildet wird. Das ist vermutlich Aufgabe der Datenverarbeitungseinrichtung, die ihrerseits ein stationäres oder mobiles Endgerät ist (Anspruch 8). Die Kommunikation zwischen der UV-Messeinrichtung und der Datenverarbeitungseinrichtung erfolgt bevorzugt drahtlos, wobei nicht angegeben wird, wie diese Kommunikation gegenständlich realisiert wird. Das offenbarte Dosimeter mit Endgerät ist nicht als dünnes Filmdosimeter vorgesehen, sondern wird in einem Gehäuse (Anspruch 18) untergebracht. Unabhängig von der unvollständig beschriebenen Funktionsweise erscheint das angegebene Dosimeter als mögliche Vorlage für eine mögliche drucktechnische Fertigung nicht geeignet, da auf Grund der Komplexität die Fertigung sehr aufwändig wäre.

In DE 10 2007 041395 A1 wird ein energieautarkes, dünnes, flexibles und preiswertes Filmdosimeter beschrieben, dass als integrierte Schaltung von gedruckten Dünnschichtbauelementen auf einem flexiblen Substrat hergestellt wird. Ein Nachteil dieser Lösung ist, dass eine Vielzahl von verschiedenen Bauelementen (UV-Diode, Solarzellen, Kondensator, Transistoren, Display, akustischer Alarm) erforderlich ist, die sehr hohe spezifische Anforderungen an die Schaltungsentwicklung und die Fertigung durch Druckprozesse stellen. Unter Verwendung der vorliegenden Erfindung können diese Fertigungsprozesse stark vereinfacht werden.

Es bestand daher die Aufgabe, ein möglichst einfaches UV-Dosimeter bereitzustellen, dass die beschriebenen Nachteile der bekannten Vorrichtungen nicht mehr aufweist.

Gelöst wird die Aufgabe durch ein flexibles, energieautarkes UV-Dosimeter, das auch für den einmaligen Gebrauch geeignet ist, welches die absorbierte Dosis in Abhängigkeit von Intensität und Dauer der Bestrahlung und Zeit durch Farbänderung optisch anzeigt und ohne eine zusätzliche Energiequelle funktionsfähig ist. Es ist dadurch gekennzeichnet, dass es aus einem oder mehreren UV-Dosimeter-Modulen besteht, wobei jedes UV-Dosimeter-Modul zwei funktionellen Bauelemente umfaßt, nämlich eine UV-sensitive Fotodiode und ein elektrochromes Element, die auf einer gemeinsamen Elektrode angeordnet sind. Das elektrochrome Element ist ein inhärenter Bestandteil der Messschaltung. Es akkumuliert die von der UV-sensitiven Fotodiode generierte Ladung und zeigt nach Erreichen einer vorbestimmten elektrischen Ladungsdichte dies durch eine Farbänderung an.

Das erfindungsgemäße UV-Dosimeter umfasst mindestens ein UV-Dosimeter-Modul. Das UV-Dosimeter-Modul umfasst eine gemeinsame transparente Elektrode (11), die eine Schicht aus einem transparenten Metalloxid auf einem transparenten flexiblen Substrat ist, und darauf angeordnete weitere Schichten einer oder mehrerer UV-Fotodioden (2) und des elektrochromen Elements (1). Die weiteren Schichten der UV-sensitiven Fotodiode sind eine Schicht (21) aus einem polymeren Lochleitermaterial, eine halbleitende UV-Absorberschicht (22) und eine Kathode (23). Die weiteren Schichten des elektrochromen Anzeigeelements (1) sind eine Ionenspeicherschicht (12), eine Elektrolytschicht (13), eine elektrochrome Schicht (14) aus einem redoxaktiven Material und eine bevorzugt transparente Elektrode (15). Zwischen der Fotodiode (2) und elektrochromem Anzeigeelement (1) liegt ein Isolator (4). Die beiden Elektroden (15, 23) sind durch eine elektrische Leiterbahn (5) verbunden.

Das UV-Dosimeter basiert somit auf einer sehr einfachen elektronischen Schaltung zur Bestimmung der Dosis von UV-Strahlung, die auf einen Menschen oder ein Objekt einwirkt. Die aktiven Bestandteile sind ausschließlich eine oder mehrere UV-Fotodioden und mindestens ein elektrochromes Element, welches die akkumulierte Strahlendosis in Abhängigkeit von Bestrahlung und Zeit durch eine Farbänderung anzeigt. Das elektrochrome Element akkumuliert die im Messzeitraum von der UV-Fotodiode generierte Ladung und bringt diese als Farbänderung zur Anzeige. Das Dosimeter funktioniert ohne zusätzliche Stromquelle, wie z.B. Batterien oder Solarzellen. Auf Grund der Einfachheit der Schaltung kann das UV-Dosimeter in einer bevorzugten Ausführungsform als dünnes, flexibles Foliendosimeter preisgünstig mittels Druck- und Beschichtungstechniken hergestellt werden, wodurch sich die Vorteile eines fotochromen Filmdosimeters mit denen eines elektronischen Dosimeters zusammenführen lassen. Im Gebrauch kann es platzsparend direkt an den exponierten Oberflächen angebracht werden. Dies ist z.B. von Bedeutung beim Sonnenbaden unter natürlichem oder künstlichen Sonnenlicht, sonstigen Freizeit- oder Arbeitsaktivitäten im Freien oder in technischen Prozessen, bei denen UV-härtende Materialien verarbeitet werden. Darüber hinaus kann man, anders als bei fotochromen Dosimetern, durch geeignete Dimensionierung der Bauelemente verschiedene Messbereiche über einen großen Empfindlichkeits-bereich realisieren und durch Kurzschließen der EC-Zelle die Färbung zurücksetzen und somit das Dosimeter auch mehrfach verwenden.

Aufgabe der Erfindung ist es somit, die Nachteile bestehender elektronischer Lösungen wie voluminöser und starrer Aufbau durch diskrete Bauelemente, aufwendige Fertigung auf Grund hoher Schaltungskomplexität und bestehender fotochromer Dosimeter wie beschränkter Messbereich und nur qualitative Anzeige zu überwinden und dabei einzelne wesentliche Vorteile der bestehenden Lösungen wie Flexibilität und Reversibilität zu bewahren. Die Lösung der erfinderischen Aufgabe erfolgt durch eine einfache Schaltung geringer Komplexität für ein UV-Dosimeter zur Bestimmung der Dosis von UV-Strahlung, die ohne zusätzliche Energieversorgung auskommt und als dünnes, flexibles Foliendosimeter preisgünstig mittels Druck- und Beschichtungstechniken hergestellt werden kann.

Konkret wird die Lösung der Aufgabe dadurch erreicht, dass das Dosimeter als integrierte Schaltung aus nur zwei Bauelementtypen, nämlich UV-Fotodioden (2) und elektrochromen Anzeigeelementen (1), realisiert wird. Die von den UV-Fotodioden (2) bei UV-Einstrahlung gelieferte Ladung wird von den elektrochromen Anzeigeelementen (1) akkumuliert und steuert deren Farbänderung, die wiederum eine grafische Anzeige des Dosiswerts ermöglicht. Die elektrochromen Anzeigeelemente (1) erfüllen also eine duale Funktion als Ladungsspeicher und farbändernde Anzeige. Die Ladungsspeicherfunktion ergibt sich aus der großen Kapazität von mehr als 1 µF/cm² in Kombination mit der ablaufenden reversiblen Oxidation des elektrochromen Materials, wodurch die Ladungen gebunden werden. Der Zeitpunkt des Farbumschlags ist proportional zum Strom und zur Expositionszeit und damit zur akkumulierten Ladung und somit ein Maß für die eingestrahlte UV-Dosis. Da für das Schalten des elektrochromen Anzeigeelements (1) eine bestimmte Spannung erforderlich ist, sind ggf. mehrere UV-Fotodioden (2) in Reihe oder parallel zu schalten. Durch eine geeignete elektrische und geometrische Dimensionierung der UV-Fotodioden (2) und elektrochromen Anzeigeelemente (1) können verschiedene Empfindlichkeitsbereiche und Parameter für das Dosimeter realisiert werden. Möglichkeiten zur elektrischen Dimensionierung ergeben sich z.B. durch die Wahl der fotoaktiven und/oder der elektrochromen redoxaktiven Materialien und deren Schichtdicken. Eine geometrische Dimensionierung ist durch die Wahl des Flächenverhältnisses von UV-Fotodiode (2) und elektrochromem Anzeigeelement (1) möglich. Je nach Erfordernis können eine oder auch mehrere in Reihe oder parallel geschaltete Fotodioden ein elektrochromes Element steuern.

Dadurch, dass nur zwei Bauelementtypen verwendet werden und diese schichtartig in einzelnen Funktionsschichten aufgebaut sind, ist die Komplexität der integrierten Schaltung gering, so dass der Schaltungsentwurf und dessen technische Umsetzung mit Druck- und Beschichtungstechniken einfach zu realisieren sind. Insbesondere wird die Zahl der benötigten Funktionsmaterialien und damit der erforderlichen Verfahrensschritte begrenzt.

Bei der Herstellung des erfindungsgemäßen UV-Dosimeters werden die funktionellen Schichten aus geeigneten Lösungen oder Dispersionen auf die transparente Elektrode (11) gedruckt. Geeignete Druckverfahren sind z.B. Tintenstrahl-, Sieb-, Offset-, Hoch- oder Tiefdruck oder Aerosoljetdruck. Alternativ zum Drucken können auch andere Beschichtungstechniken wie Rakeln, Freifallbeschichtung, Gießbeschichtung, Tauchbeschichtung, Elektrodeposition und Spincoating einbezogen werden. Ggf. erforderliche anorganische Schichten können ebenfalls durch Druckverfahren mittels Nanopartikeldispersionen aber auch durch Aufdampfen oder Sputtern realisiert werden.

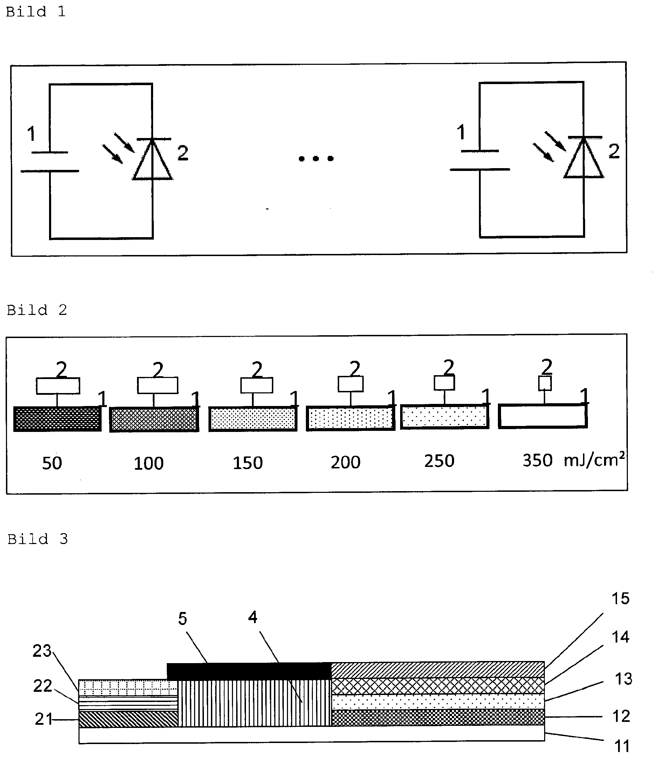

In Bild 1 ist ein Blockschaltbild mehrerer UV-Dosimeter-Module auf einem gemeinsamen Träger (3) dargestellt. In einer besonderen bevorzugten Ausführungsform sind flexibler Träger (3) und transparente Elektrode (11) identisch. Ein UV-Dosimeter-Modul besteht aus der Kombination von elektrochromem Element (1) und ein oder mehrerer Fotodioden (2) entsprechend Bild 3.

Bild 2 zeigt ein Schema einer Anordnung von UV-Dosimetern verschiedener Empfindlichkeit; die unterschiedlichen Empfindlichkeiten werden hierbei durch Variation der Fläche der UV-Fotodiode (2) erzielt, wobei die Empfindlichkeit der Dosimeter mit zunehmender Fläche der UV-Fotodiode zunimmt.

In Bild 3 ist der schematische Aufbau eines Dosimetermoduls dargestellt. Das Dosimeter ist realisiert durch schichtweises Aufbringen der Funktionsschichten auf einer gemeinsamen transparenten Elektrode (11); die Funktionselemente der UV-Fotodiode (zugehörig 11 / 21 / 22 / 23) sind durch einen Isolator (4) von den Funktionsschichten des EC-Moduls (zugehörig 11 / 12 / 13 / 14 / 15) getrennt; die Leiterbahn (5) verbindet die Kathode (23) mit der bevorzugt transparenten Elektrode (15). Eine der äußeren Schichten des Dosimetermoduls ist eine leitfähige Schicht, die transparente Elektrode (11). Auf der Elektrode (11) werden die Schichten der Fotodiode (2) und die Schichten des elektrochromen Elementes (1) positoniert, die Schichten der Fotodiode (2) und des elektrochromen Elementes (1) sind durch einen Isolator (4) getrennt und durch eine Elektrode begrenzt (15, 23). Diese Elektroden (15, 23) sind durch eine Leiterbahn (5) verbunden. Für die Fotodiode umfassen die einzelnen Schichten die gemeinsame Elektrode (11), eine Lochleiterschicht (21), eine halbleitende UV-Absorberschicht (22) und eine abschließende Kathode (23). Das elektrochrome Element umfasst die folgenden Schichten: gemeinsame Elektrode (11), Ionenspeicherschicht (12), Elektrolyt (13), elektrochrome Schicht aus einem redoxaktiven Material (14) und transparente Elektrode (15). Sind sowohl Elektrode (11) und Elektrode (15) aus einem transparenten Material hat das zusätzliche Effekte der Anzeige der gemessenen UV-Strahlendosis zur Folge, man könnte durch das elektrochrome Anzeigeelement die Oberfläche des Trägers sehen und es könnten dann zum Beispiel Markierungen auf der Oberfläche von Träger 3 offen gelegt oder verdeckt werden. Zum Beispiel könnten auf der Oberfläche Farbskalen zu sehen sein, die einen Vergleich mit der Anzeige des elektrochromen Elements erlauben. Sind die Kathode (23) und/oder die Elektrode (15) nicht transparent, dann muss die transparente Elektrode (11) dem Licht bzw. dem Betrachter zugewandt sein. Eine im Sinne der Erfindung geeignete UV-Fotodiode (2) ist z.B. eine Bulk-Heterojunction Diode mit dem Schichtaufbau transparente Elektrode / Lochleiter / halbleitende UV-Absorberschicht / Kathode (Bild 3), deren halbleitende UV-Absorberschicht (22) aus einem halbleitenden konjugierten Polymer und einem Fullerenderivat besteht. Das konjugierte Halbleitermaterial sollte eine Bandlücke größer ca. 3 eV aufweisen, so dass nur UV-Licht absorbiert wird. Die transparente Elektrode (11) kann z.B. aus einer dünnen Schicht eines transparenten leitenden Oxids (z.B. Indium-Zinn-Oxid - ITO, ZnO, Fluor-Zinn-Oxid - FTO) auf einem transparenten und flexiblen Substrat bestehen. Der Lochleiter (21) ist z.B. ein transparentes leitfähiges Polymer wie Polyethylendioxythiophen dotiert mit Polystyrensulfonsäure. Die Kathode (23) besteht im Allgemeinen aus Aluminium und kann sowohl vollflächig oder auch strukturiert, z.B. kammartig, aufgebracht sein. Eine strukturiert aufgebrachte Kathode (23) hat den Vorteil, dass diese dadurch lichtdurchlässig ist.

Ein im Sinne der Erfindung geeignetes elektrochromes Anzeigeelement (1) besteht aus den Elektroden (11) und (15), einem redoxaktiven Polymer (14), einer Ionenspeicherschicht (12) und einer Elektrolytschicht (13) (Bild 3). Die Elektroden (11) und (15) bestehen wiederum z.B. aus einer dünnen Schicht eines transparenten leitenden Oxids (z.B. ITO, ZnO, FTO) auf einem transparenten und flexiblen Substrat. Die Ionenspeicherschicht (12) ist z.B. ein Mischoxid aus CeO₂ und TiO₂. Das redoxaktive Polymer kann je nach gewünschter Farbänderung z.B. Polyethylendioxythiophen, Poly-3-hexylthiophen, Poly-TPD-4Me-DPX oder irgendein anderes geeignetes Polymer sein. Der Elektrolyt (13) besteht aus einem Polymergel und einem Leitsalz (z.B. LiClO₄)

Eine Herausforderung bei der Schaltungsentwicklung besteht darin, die organischen oder polymeren UV-Fotodioden und die elektrochromen Anzeigeelemente so zu dimensionieren, dass der Farbwechsel der elektrochromen Anzeigeelemente bei unterschiedlichen Dosiswerten stattfindet. Dieses Erfordernis wird dadurch gelöst, dass verschiedene, die Kennlinien der Bauelemente beeinflussende Parameter wie Absorptionskoeffizient, Ladungsträgerbeweglichkeit, Schichtdicken oder Flächen variiert werden. Durch Verwendung mehrerer unterschiedlich dimensionierter erfindungsgemäßer Schaltungen auf einer gemeinsamen Elektrode können verschiedene Dosisbereiche abgedeckt werden. Kombiniert man z.B. eine Fotodiode, die bei voller Sonneneinstrahlung einen Strom von 1 mA/cm² liefert mit einem elektrochromen Anzeigeelement, das bei einer Ladungsdichte von 2 mC/cm² vollständig umschaltet und wählt man ein Flächenverhältnis der Diode zum elektrochromen Anzeigeelement von 1:500, so beträgt der Zeitraum bis zum vollständigen Umschalten der Farbe 1000 s. Gestaltet man das elektrochrome Anzeigeelement einer jeden, unterschiedlich sensitiven Paarung geometrisch verschieden, z.B. als Ziffer oder verschieden lange Balken, so kann man dadurch den jeweiligen Dosiswert quantitativ darstellen.

Der gesamte Schaltungsaufbau kann bei Bedarf mittels transparenter Hochbarriereschichten oder -folien gekapselt werden.

Zur besseren Haftung an Personen oder Gegenständen kann die Rückseite des UV-Dosimeters mit einer Kleberschicht beaufschlagt werden, so dass der Sensor ähnlich einem Pflaster oder einem Klebestreifen benutzt werden kann.

Das erfindungsgemäße UV-Dosimeter kann in Form eines kleinen Teststreifens platzsparend am Körper, der Kleidung oder Gegenständen angebracht werden. Damit befindet es sich, ohne dass es dort stört, vorteilhafterweise direkt auf der exponierten Oberfläche und kann so die dort auftreffende Dosis messen. Sind mehrere Flächen eines Körpers unterschiedlichen Dosen ausgesetzt, so kann jede der Flächen mit einem Streifendosimeter bestückt werden. Klein bedeutet hier eine Fläche des flexiblen Streifendosimeters von weniger als 10 cm², bevorzugt weniger als 5 cm² und eine Gesamtdicke von maximal 250 um, bevorzugt kleiner als 200 um. Auf Grund der geringen Fertigungskosten ist es für den einmaligen Gebrauch geeignet, kann bei Bedarf aber auch mehrfach verwendet werden. Sollte es erforderlich sein, kann das UV-Dosimeter natürlich auch in größeren Ausmaßen als 10 cm² angefertigt werden.

### Beispiel 1

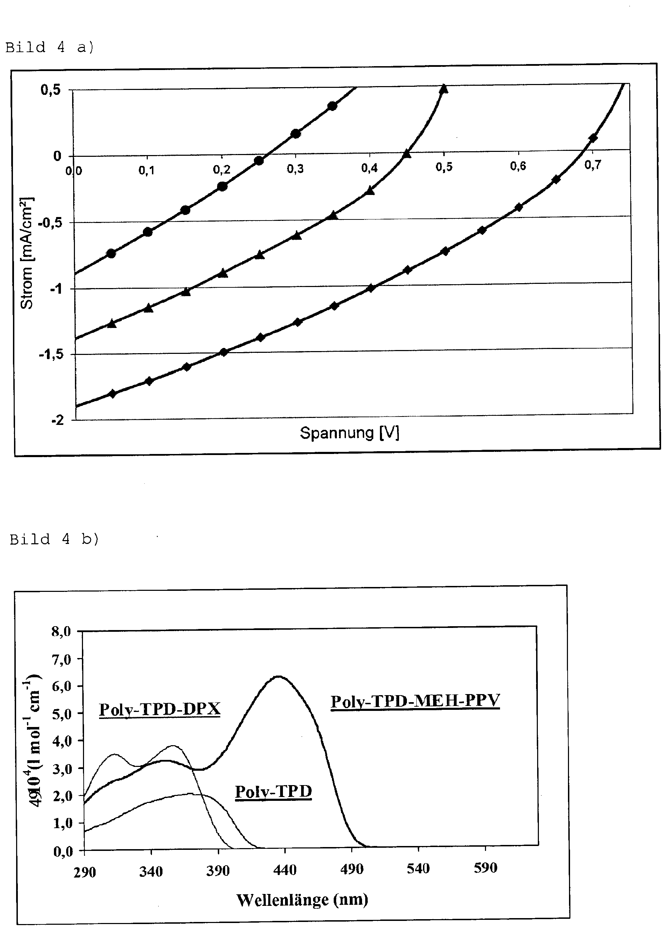

Dieses Beispiel zeigt verschiedene Varianten der Realisierung einer UV-empfindlichen Fotodiode (Bild 3). Der Schichtaufbau der Fotodiode (11/21/22/23) ist ITO / Polyethylendioxythiophen : Polystyrensulfonsäure / Polytriphenyl-amin-derivat : [6,6]-Phenyl-C₆₁-Butyrsäuremethylester / Aluminium, wobei es sich bei den Polytriphenylaminderivaten um Poly-4'-butyl-triphenylamin-4,4'-diyl (Poly-TPD), Poly-4-methyl-triphenyldiamin-diphenyl-*p*-xylyliden (Poly-TPD-DPX) und Poly[1,4-phenylen-(4-methylphenyl)imino-4,4'-diphenylen-(4-methylphenyl)imino-1,4-phenylenvinylen-2-methoxy-5-(2-ethyl-hexyloxy)-1,4-phenylen-vinylen] (Poly-TPD:MeH-PPV) handelt. Bei Bestrahlung mit einem Sonnensimulator (1 kW/m², AM 1.5) generieren die Fotodioden Stromdichten je nach Lage des Arbeitspunkts zwischen 0,5 mA/cm² und 1,5 mA/cm² (Bild 4 a). Spektroskopische Messungen zeigen eine Absorption überwiegend im UV-Bereich (λ < 400nm) (Bild 4 b).

### Beispiel 2

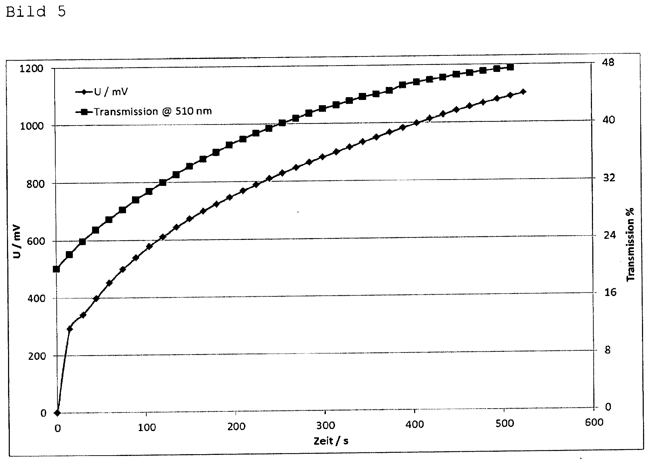

Dieses Beispiel demonstriert die Umfärbung eines elektrochromen Moduls (1) durch den in einem UV-Diodenmodul (2) generierten Strom. Die Schaltung entspricht dem Schaltbild in Bild 1. Der Schichtaufbau (11/21/22/23) des UV-Diodenmoduls ist ITO / Poly-ethylendioxythiophen:Polystyrensulfonsäure / Poly-3-hexyl-thiophen:[6,6]-Phenyl-C₆₁-Butyrsäuremethyl-ester / Aluminium. Der UV-Diodenmodul besteht aus 5 in Reihe geschalteten Dioden, die eine Leerlaufspannung bei Bestrahlung mit UV-Licht von 1,85 V erzeugen. Der Schichtaufbau (11/12/13/14/15) des elektrochromen Moduls ist FTO / Poly-3-hexylthiophen / Polymerelektrolyt / Titandioxid:Ceriumoxid / FTO. Das Verhältnis der Fläche des UV-Diodenmoduls zur Fläche des EC-Moduls beträgt 1:1,5. Der UV-Diodenmodul wurde mit UV-Licht der Wellenlänge 300-400nm (Maximum bei 352 nm) bei einer Bestrahlungsleistung von 500 µW/cm² bestrahlt. Dadurch fließt ein Strom infolge dessen sich am EC-Modul eine Spannung aufbaut (Bild 5). Gleichzeitig steigt die Transmission im Wellenlängenbereich von 400 nm bis 600 nm und verringert sich im Wellenlängenbereich von 600 nm bis 800 nm. Das führt zu einer Verfärbung von violett zu grau, was nach ca. 5 Minuten auch visuell deutlich zu erkennen ist. In Bild 5 ist die Zunahme der Transmission bei 510 nm dargestellt. Die für die Verfärbung erforderliche Strahlendosis beträgt 150 mJ/cm². Durch Variation des Flächenverhältnisses kann die für das Umfärben erforderliche Dosis in einem weiten Bereich sowohl zu kleineren als auch zu größeren Werten verschoben werden.

### [Bezugszeichenliste]

- 1: Elektrochromes Anzeigeelement
- 2: UV-Fotodiode oder UV-Fotodiodenmodul
- 3: Träger
- 4: Isolator
- 5: Leiterbahn
- 11: transparente Elektrode
- 12: Ionenspeicherschicht
- 13: Elektrolyt
- 14: elektrochrome Schicht aus einem redoxaktiven Material
- 15: Elektrode
- 21: Lochleiter
- 22: halbleitende UV-Absorberschicht
- 23: Kathode

### Anzahl anhängende Abbildungen: 6

Bild 1: Blockschaltbild mehrerer UV-Dosimeter-Module auf einem gemeinsamen Träger (3)
Bild 2: Schema einer Anordnung von UV-Dosimetern verschiedener Empfindlichkeit;
Bild 3: schematischer Aufbau eines Dosimetermoduls
Bild 4 a) und b): Kennlinien von UV-Dioden und zugehörige Absorptionsspektren der UV-empfindlichen Halbleitermaterialien nach Beispiel 1
Bild 5: Zeitliche Änderung der Spannung und der optischen Transmission bei 510 nm Wellenlänge des elektrochromen Elements eines UV-Dosimeters gemäß Beispiel 2

## Patentansprüche

1. Flexibles, energieautarkes UV-Dosimeter welches die absorbierte Dosis in Abhängigkeit von Intensität und Dauer der Bestrahlung durch Farbänderung optisch anzeigt und ohne eine zusätzliche Energiequelle funktionsfähig ist, und welches aus einem oder mehreren UV-Dosimeter-Modulen besteht, wobei jedes UV-Dosimeter-Modul eine oder mehrere UV-sensitive Fotodiode(n) (2) und ein elektrochromes Element (1) umfasst, die auf einer gemeinsamen Elektrode (11) angeordnet sind, und das elektrochrome Element die von der UV-sensitiven Fotodiode generierte Ladung akkumuliert und diese durch Farbänderung anzeigt, wobei die gemeinsame transparente Elektrode (11) eine Schicht aus einem transparenten Metalloxid auf einem transparenten flexiblen Substrat ist, auf der weitere Schichten angeordnet sind, wobei die weiteren Schichten der UV-sensitiven Fotodiode eine Schicht (21) aus einem polymeren Lochleitermaterial, eine halbleitende UV-Absorberschicht (22) und eine Kathode (23) sind und die weiteren Schichten des elektrochromen Elements (1) eine Ionenspeicherschicht (12), eine Elektrolytschicht (13), eine elektrochrome Schicht (14) aus einem redoxaktiven Material und eine Elektrode (15) sind, wobei zwischen Fotodiode (2) und elektrochromem Anzeigeelement (1) ein Isolator (4) liegt und die beiden Elektroden (15, 23) durch eine elektrische Leiterbahn (5) verbunden sind.

2. UV-Dosimeter nach Anspruch 1, **dadurch gekennzeichnet, dass** es mehrere UV-Dosimeter-Module mit unterschiedlicher Empfindlichkeit umfasst.

3. UV-Dosimeter nach Anspruch 1 oder 2, **dadurch gekennzeichnet, dass** die Variation der Empfindlichkeit durch Variation der aktiven Fläche der UV-Fotodiode (2) und/oder des elektrochromen Elements (1) erfolgt.

4. UV-Dosimeter nach einem oder mehreren der Ansprüche 1 bis 3, **dadurch gekennzeichnet, dass** die Variation der Empfindlichkeit durch Variation der fotoaktiven Materialien in der fotoaktiven Schicht (22) und/oder der redoxaktiven Materialien in der elektrochromen Schicht (14) und/oder der Dicke der Schichten mit aktiven Materialien erfolgt.

5. UV-Dosimeter nach Anspruch 1, **dadurch gekennzeichnet, dass** es durch elektrisches Kurzschließen des elektrochromen Elements (1) in den Ausgangszustand zurückgesetzt werden kann.

6. UV-Dosimeter nach einem oder mehreren der Ansprüche 1 bis 5, **dadurch gekennzeichnet, dass** es nicht größer als 10 cm², besonders bevorzugt nicht größer als 2 cm² ist.

7. UV-Dosimeter nach Anspruch 1, **dadurch gekennzeichnet, dass** das Dosimeter mit einer Adhäsionsschicht versehen ist und/oder der gesamte Schaltungsaufbau bestehend aus elektrochromem Element (1) und Fotodiode (2) mittels transparenter Hochbarriereschichten oder -folien gekapselt ist.

8. UV-Dosimeter nach Anspruch 1, **dadurch gekennzeichnet, dass** in einer spezifischen Ausführungsform die UV-sensitive Fotodiode (2) den Schichtaufbau transparente Elektrode (11) / Lochleiter (21) / halbleitende UV-Absorberschicht (22) / Kathode (23) aufweist.

9. UV-Dosimeter nach Anspruch 8, **dadurch gekennzeichnet, dass** die halbleitende UV-Absorberschicht (22) ein halbleitendes konjugiertes Polymer und ein Fullerenderivat umfasst und das konjugierte Halbleitermaterial eine Bandlücke größer 3 eV aufweist, die transparente Elektrode (11) eine dünne Schicht eines transparenten leitenden Oxids umfasst, der Lochleiter (21) ein transparentes leitfähiges Polymer, bevorzugt Polyethylendioxythiophen dotiert mit Polystyrolsulfonsäure, umfasst und die Kathode (23) aus Aluminium besteht.

10. UV-Dosimeter nach Anspruch 1, **dadurch gekennzeichnet, dass** das elektrochrome Anzeigeelement zwei transparente Elektroden (11, 15), eine elektrochrome Schicht (14) mit einem redoxaktiven Polymer, eine Ionenspeicherschicht (12) und einen Elektrolyten (13) umfasst.

11. UV-Dosimeter nach Anspruch 10, **dadurch gekennzeichnet, dass** die Elektroden (11, 15) aus einer dünnen Schicht eines transparenten leitenden Oxids bestehen, die Ionenspeicherschicht (12) ein Mischoxid aus CeO₂ und TiO₂ ist, das redoxaktive Polymer der elektrochromen Schicht (14) ein Polyethylendioxythiophen, Poly-3-hexylthiophen oder Poly-TPD-4Me-DPX ist und der Elektrolyt ein Polymergel und ein Leitsalz umfasst.

12. Verfahren zur Herstellung eines UV-Dosimeters gemäß einem oder mehreren der Ansprüche 1 bis 11, **dadurch gekennzeichnet, dass** die transparente gemeinsame Elektrode (11) und alle darauf angeordneten Schichten der UV-Fotodiode (2) wie Lochleiter (21), halbleitende UV-Absorberschicht (22) und Kathode (23) und des elektrochromen Anzeigeelements (1) wie Ionenspeicherschicht (12), Elektrolytschicht (13), elektrochrome Schicht aus einem redoxaktiven Material (14) und transparente Elektrode (15), sowie der zwischen Fotodiode (2) und elektrochromen Anzeigeelement (1) liegende Isolator (4) und die die beiden Elektroden (15) und (23) verbindende Leiterbahn (5) als integrierte Schaltungen in Dünnschichttechnik durch sukzessives Aufbringen und Strukturieren von organischen oder anorganischen Funktionsschichten hergestellt werden.

## Claims

1. Flexible, energy self-sufficient UV dosimeter which optically displays the absorbed dose by a colour change as a function of the intensity and duration of the exposure and which can function without an additional energy source, and consists of one or more UV dosimeter modules, each UV dosimeter module comprising one or more UV-sensitive photodiode(s) (2) and an electrochromic element (1), which are arranged on a common electrode (11), and the electrochromic element accumulating the charge generated by the UV-sensitive photodiode and displaying this by a colour change, the common transparent electrode (11) having a layer of a transparent metal oxide on a transparent flexible substrate, on which further layers are arranged, the further layers of the UV-sensitive photodiode being a layer (21) of a polymeric hole conductor material, a semiconducting UV absorber layer (22) and a cathode (23), and the further layers of the electrochromic element (1) being an ion storage layer (12), an electrolyte layer (13), an electrochromic layer (14) of a redox-active material and an electrode (15), an insulator (4) being located between the photodiode (2) and the electrochromic display element (1) and the two electrodes (15, 23) being connected by an electrical conductor track (5).

2. UV dosimeter according to Claim 1, **characterized in that** it comprises a plurality of UV-dosimeter modules having different sensitivities.

3. UV dosimeter according to Claim 1 or 2, **characterized in that** the variation of the sensitivity is carried out by varying the active area of the UV photodiode (2) and/or of the electrochromic element (1).

4. UV dosimeter according to one or more of Claims 1 to 3, **characterized in that** the variation of the sensitivity is carried out by varying the photoactive materials in the photoactive layer (22) and/or the redox-active materials in the electrochromic layer (14) and/or the thickness of the layers having active materials.

5. UV dosimeter according to Claim 1, **characterized in that** it can be reset into the initial state by electrical short-circuiting of the electrochromic element (1).

6. UV dosimeter according to one or more of Claims 1 to 5, **characterized in that** it is no larger than 10 cm², particularly preferably no larger than 2 cm².

7. UV dosimeter according to Claim 1, **characterized in that** the dosimeter is provided with an adhesion layer, and/or the entire circuit structure, consisting of the electrochromic element (1) and the photodiode (2) is encapsulated by means of transparent high-barrier layers or films.

8. UV dosimeter according to Claim 1, **characterized in that**, in one specific embodiment, the UV-sensitive photodiode (2) has the layer structure: transparent electrode (11)/hole conductor (21)/semiconducting UV absorber layer (22)/cathode (23).

9. UV dosimeter according to Claim 8, **characterized in that** the semiconducting UV absorber layer (22) comprises a semiconducting conjugated polymer and a fullerene derivative, and the conjugated semiconductor material has a bandgap of more than 3 eV, the transparent electrode (11) comprises a thin layer of a transparent conductive oxide, the hole conductor (21) comprises a transparent conductive polymer, preferably polyethylene dioxythiophene doped with polystyrene sulfonic acid, and the cathode (23) consists of aluminium.

10. UV dosimeter according to Claim 1, **characterized in that** the electrochromic display element comprises two transparent electrodes (11, 15), an electrochromic layer (14) having a redox-active polymer, an ion storage layer (12) and an electrolyte (13).

11. UV dosimeter according to Claim 10, **characterized in that** the electrodes (11, 15) consist of a thin layer of a transparent conductive oxide, the ion storage layer (12) is a mixed oxide of CeO₂ and TiO₂, the redox-active polymer of the electrochromic layer (14) is a polyethylene dioxythiophene, poly-3-hexylthiophene or poly-TPD-4Me-DPX, and the electrolyte comprises a polymer gel and a conducting salt.

12. Method for producing a UV dosimeter according to one or more of Claims 1 to 11, **characterized in that** the transparent common electrode (11) and all layers arranged thereon of the UV photodiode (2), such as the hole conductor (21), the semiconducting UV absorber layer (22) and the cathode (23), and of the electrochromic display element (1), such as the ion storage layer (12), the electrolyte layer (13), the electrochromic layer of a redox-active material (14) and the transparent electrode (15), as well as the insulator (4) located between the photodiode (2) and the electrochromic display element (1) and the conductor track (5) connecting the two electrodes (15) and (23), are produced as integrated circuits by thin-film techniques by successive application and structuring of organic or inorganic functional layers.

## Revendications

1. Dosimètre UV flexible, autonome en énergie, qui indique optiquement la dose absorbée en fonction de l'intensité et de la durée de l'irradiation par un changement de couleur et pouvant fonctionner sans source d'énergie supplémentaire, et qui consiste en un ou plusieurs modules de dosimètre UV, dans lequel chaque module de dosimètre UV comprend une ou plusieurs photodiode(s) sensible(s) aux UV (2) et un élément électrochromique (1), qui sont agencés sur une électrode commune (11), et l'élément électrochromique accumule la charge générée par la photodiode sensible aux UV et l'indique par un changement de couleur, dans lequel l'électrode transparente commune (11) est une couche d'oxyde métallique transparent sur un substrat flexible transparent, sur laquelle sont agencées d'autres couches, dans lequel les autres couches de la photodiode sensible aux UV sont une couche (21) en un matériau polymère conducteur de trous, une couche semi-conductrice absorbant les UV (22) et une cathode (23) et les autres couches de l'élément électrochromique (1) sont une couche de stockage d'ions (12), une couche d'électrolyte (13), une couche électrochromique (14) en un matériau à activité redox et une électrode (15), dans lequel un isolant (4) se trouve entre la photodiode (2) et l'élément d'affichage électrochromique (1) et les deux électrodes (15, 23) sont reliées par une piste conductrice (5) électrique.

2. Dosimètre UV selon la revendication 1, **caractérisé en ce qu'**il comprend plusieurs modules de dosimètre UV de sensibilité différente.

3. Dosimètre UV selon la revendication 1 ou 2, **caractérisé en ce que** la variation de la sensibilité est effectuée en faisant varier la surface active de la photodiode UV (2) et/ou de l'élément électrochromique (1).

4. Dosimètre UV selon l'une quelconque ou plusieurs des revendications 1 à 3, **caractérisé en ce que** la variation de la sensibilité est obtenue en faisant varier les matériaux photoactifs dans la couche photoactive (22) et/ou les matériaux à activité redox dans la couche électrochromique (14) et/ou l'épaisseur des couches de matériaux actifs.

5. Dosimètre UV selon la revendication 1, **caractérisé en ce qu'**il peut être remis à l'état initial par court-circuitage électrique de l'élément électrochromique (1).

6. Dosimètre UV selon l'une quelconque ou plusieurs des revendications 1 à 5, **caractérisé en ce qu'**il n'est pas plus grand que 10 cm², de préférence pas plus grand que 2 cm².

7. Dosimètre UV selon la revendication 1, **caractérisé en ce que** le dosimètre est pourvu d'une couche d'adhérence et/ou l'ensemble de la structure de circuit consistant en l'élément électrochromique (1) et la photodiode (2) est encapsulé au moyen de couches ou de films transparents à haute barrière.

8. Dosimètre UV selon la revendication 1, **caractérisé en ce que**, dans une forme de réalisation spécifique, la photodiode sensible aux UV (2) présente la structure en couches électrode transparente (11) / conducteur à trous (21) / couche absorbante UV semi-conductrice (22) / cathode (23).

9. Dosimètre UV selon la revendication 8, **caractérisé en ce que** la couche absorbante UV semi-conductrice (22) comprend un polymère conjugué semi-conducteur et un dérivé de fullerène, et le matériau semi-conducteur conjugué présente un écart énergétique supérieur à 3 eV, l'électrode transparente (11) comprend une couche mince d'un oxyde conducteur transparent, le conducteur à trous (21) comprend un polymère conducteur transparent, de préférence du polyéthylènedioxythiophène dopé avec de l'acide polystyrène sulfonique, et la cathode (23) consiste en de l'aluminium.

10. Dosimètre UV selon la revendication 1, **caractérisé en ce que** l'élément d'affichage électrochromique comprend deux électrodes transparentes (11, 15), une couche électrochromique (14) avec un polymère à activité redox, une couche de stockage d'ions (12) et un électrolyte (13).

11. Dosimètre UV selon la revendication 10, **caractérisé en ce que** les électrodes (11, 15) consistent en une couche mince d'un oxyde conducteur transparent, la couche de stockage d'ions (12) est un oxyde mixte de CeO₂ et TiO₂, le polymère à activité redox de la couche électrochromique (14) est un polyéthylènedioxythiophène, un poly-3-hexylthiophène ou un poly-TPD-4Me-DPX et l'électrolyte comprend un gel polymère et un sel conducteur.

12. Procédé de fabrication d'un dosimètre UV selon l'une quelconque ou plusieurs des revendications 1 à 11, **caractérisé en ce que** l'électrode commune transparente (11) et toutes les couches de la photodiode UV (2) agencées sur celle-ci, telles que le conducteur à trous (21), la couche d'absorption UV semi-conductrice (22) et la cathode (23), et de l'élément d'affichage électrochromique (1), telles que la couche de stockage d'ions (12), la couche d'électrolyte (13), la couche électrochromique en un matériau à activité redox (14) et l'électrode transparente (15), ainsi que l'isolant (4) situé entre la photodiode (2) et l'élément d'affichage électrochromique (1) et la piste conductrice (5) reliant les deux électrodes (15) et (23) sont fabriqués sous forme de circuits intégrés selon la technique des couches minces par application et structuration successives de couches fonctionnelles organiques ou inorganiques.
